# EUROPEAN PATENT APPLICATION

(11) **EP 3 799 123 A1**
(43) Date of publication of application: **31.03.2021**
(21) Application number: 19919564.5
(22) Date of filing: 30.07.2019
(51) Int. Cl.: H01L 27/146, G01S 17/08, G06K 9/20

(54) **IMAGE SENSOR AND METHOD FOR MANUFACTURING SAME, CHIP, AND HANDHELD APPARATUS**

(71) Applicant: SHENZHEN GOODIX TECHNOLOGY CO., LTD., Shenzhen, Guangdong 518045 (CN)
(72) Inventor: YANG, Meng-Ta, Shenzhen, Guangdong 518045 (CN)
(74) Representative: Padial Martinez, Ana Belen
(86) International application number: PCT/CN2019/098285
(87) International publication number: WO 2021/016839

(57) **Abstract**

An image sensor (100/200/300/400/500), method of manufacturing the same, a chip and a hand-held device adopting the image sensor (100/200/300/400/500). The image sensor (100/200/300/400/500) includes a semiconductor substrate (108) and a plurality of pixels, wherein each pixel of the plurality of pixels includes: a photosensitive sensor (106), disposed on the semiconductor substrate (108); a polarizing layer (104), disposed over the semiconductor substrate (108); and a microlens (102), disposed over the polarizing layer (104), so that the polarizing layer (104) is disposed between the microlens (102) and the semiconductor substrate (108).

## Description

### TECHNICAL FIELD

The present application relates to an image sensor, a manufacturing method and a chip of the same and a hand-held device adopting the chip; in particular, to an image sensor having a polarizing layer, a method for manufacturing the image sensor, an image sensing chip, and a hand-held device.

### BACKGROUND

CMOS image sensors have been mass-produced and widely applied. Conventional image sensors may generate two-dimensional (2D) images and videos; recently, image sensors and systems capable of generating three-dimensional (3D) images attract widespread attention, these 3D image sensors can be used in applications such as facial recognition, augmented reality (AR), virtual reality (VR), drones, among others.

There are three main implementations of existing 3D image sensors: stereoscopic binocular, structured light, and time-of-flight (ToF).

The ToF approach uses specially designed pixels to determine the distance by measuring the time it takes for photons to fly and return; however, the current technology cannot generate a depth map with sufficient accuracy. In order to increase the accuracy of modeling and to reduce the cost, how to improve the accuracy of ToF sensors in a simple way has become an important task.

### SUMMARY OF THE INVENTION

One purpose of the present application is to disclose an image sensor, a manufacturing method and a chip of the same, and a hand-held device adopting the chip to address the above-mentioned issues.

One embodiment of the present application discloses an image sensor, including a semiconductor substrate and a plurality of pixels, wherein each pixel of the plurality of pixels includes: a photosensitive sensor, disposed on the semiconductor substrate; a polarizing layer, disposed over the semiconductor substrate; a microlens, disposed over the polarizing layer so that the polarizing layer is between the microlens and the semiconductor substrate.

One embodiment of the present application discloses a manufacturing method of an image sensor, including providing a semiconductor substrate; forming a polarizing layer over the semiconductor substrate; and forming a microlens over the polarizing layer.

One embodiment of the present application discloses a chip, which includes the above-mentioned image sensor.

One embodiment of the present application discloses a hand-held device, configured to perform the ToF detection, wherein the hand-held device includes: a display panel; and the above-mentioned image sensor.

Embodiments of the present application incorporate a polarizing layer in an image sensor, which improves the accuracy of the ToF sensor.

### BRIEF DESCRIPTION OF THE DRAWINGS

FIG. 1 is a cross-sectional view of one pixel of an image sensor according to an embodiment of the present application;
FIG. 2 is a top view of the image sensor shown in FIG. 1;
FIG. 3 is a cross-sectional view of the image sensor taken along the cross-sectional line shown in FIG. 2;
FIG. 4 is a top view showing four pixels of an image sensor according to an embodiment of the present application;
FIG. 5 to FIG. 9 are schematic flow diagrams illustrating the manufacturing flow of the image sensor shown in FIG. 3;
FIG. 10 is a cross-sectional view of one pixel of an image sensor according to another embodiment of the present application;
FIG. 11 is a schematic diagram illustrating a hand-held device according to an embodiment of the present application.

Reference numerals used in the drawings are summarized below:
- 100, 200, 300, 400, 500, 1000: Image sensor
- 102, 1002: Microlens
- 104, 1004: Polarizing layer
- 106, 1006: Photosensitive sensor
- 108, 1009: Semiconductor substrate
- 110, 1010: Back-end-of-line stack
- 202: Grid layer
- 202': Metal layer
- 204: Capping layer
- 1100: Hand-held device
- 1102: Image sensor
- 1104: Display screen assembly

### DETAILED DESCRIPTION

The following disclosure provides many different embodiments, or examples, for implementing different features of the invention. Specific examples of components and arrangements are described below to simplify the present disclosure. As could be appreciated, these are, of course, merely examples and are not intended to be limiting. For example, the formation of a first feature over or on a second feature in the description that follows may include embodiments in which the first and the second features are formed in direct contact, and may also include embodiments in which additional features may be formed between the first and the second features, such that the first and the second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper," and the like, may be used herein for the ease of the description to describe one element or feature's relationship with respect to another element(s) or feature(s) as illustrated in the drawings. The spatially relative terms are intended to encompass different directions of the device in use or operation in addition to the direction depicted in the figures. The apparatus may be otherwise oriented (e.g., rotated by 90 degrees or at other directions) and the spatially relative descriptors used herein may likewise be interpreted accordingly.

Notwithstanding that the numerical ranges and parameters setting forth the broad scope of the invention are approximations, the numerical values set forth in the specific examples are reported as precisely as possible. Any numerical value, however, inherently contains certain errors necessarily resulting from the standard deviation found in the respective testing measurements. Also, as used herein, the term "about" generally means within 10%, 5%, 1%, or 0.5% of a given value or range. Alternatively, the term "about" means within an acceptable standard error of the mean when considered by one of ordinary skill in the art. As could be appreciated, other than in the operating/working examples, or unless otherwise expressly specified, all of the numerical ranges, amounts, values and percentages such as those for quantities of materials, durations of times, temperatures, operating conditions, ratios of amounts, and the likes thereof disclosed herein should be understood as modified in all instances by the term "about." Accordingly, unless indicated to the contrary, the numerical parameters set forth in the present disclosure and attached claims are approximations that can vary as desired. At the very least, each numerical parameter should at least be construed considering the number of reported significant digits and by applying ordinary rounding techniques. Ranges can be expressed herein as from one endpoint to another endpoint or between two endpoints. All ranges disclosed herein are inclusive of the endpoints unless specified otherwise.

The receiving module of conventional sensors uses the image sensor to determine the time point at which the light is reflected by the object to be determined. Due to the complex reflective behavior of light in the environment, the receiving module tends to pick up a lot of unwanted noise. In view of this, the present disclosure filters the received light by arranging a polarizing layer in the image sensor of the light signal receiving module of the ToF sensor, to increase the accuracy of the ToF sensor; the details will be described hereinafter. It should be noted that even though the image sensor of the present disclosure can improve the accuracy of existing ToF sensors, such application is not a limitation to the present disclosure. In other words, the image sensor of the present disclosure can also be applied in other scenarios other than the ToF sensor.

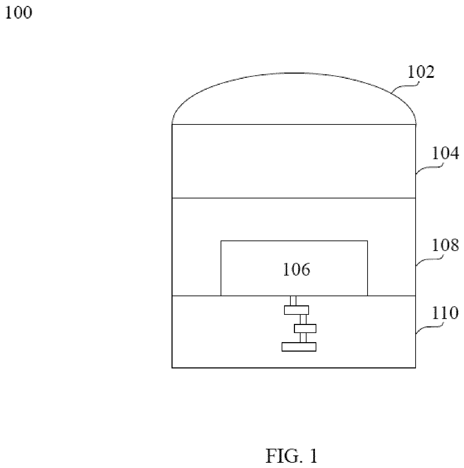

FIG. 1 is a cross-sectional view of one pixel of an image sensor according to one embodiment of the present application. It should be noted that the image sensor 100 may include a plurality of pixels, and only one pixel is illustrated in the image sensor 100 of FIG. 1. In the present embodiment, the image sensor 100 is a backside illuminated (BSI) image sensor 100, which includes a back-end-of-line (BEOL) stack 110, a semiconductor substrate 108, a polarizing layer 104, and a microlens 102. The back-end-of-line stack 110 is disposed at the front side of the semiconductor substrate 108. The back-end-of-line stack 110 includes interlayer dielectric (ILD) layers and metallization layers stacked in the ILD layers. For example, the ILD layers may include low-k dielectric (i.e., dielectric with a dielectric constant of less than about 3.9) or oxide. The metallization layers are electrically coupled with each other through vias and electrically coupled to the semiconductor substrate 108 through contacts. The metallization layer, vias, and contacts may be metals, such as aluminum-copper, geranium, copper, or some other metals.

The semiconductor substrate 108 can be a bulk semiconductor substrate, such as a bulk silicon substrate or a silicon on insulator (SOI) substrate. The photosensitive sensor 106 is disposed on the semiconductor substrate 108. The microlens 102 is arranged over the backside of the semiconductor substrate 108, and the polarizing layer 104 is disposed between the microlens 102 and the semiconductor substrate 108. The design of the polarizing layer 104 makes it difficult for the light that is not in a specific direction to pass through; that is, the light first passes through the microlens 102 and then enters the polarizing layer 104, and in this way, instead of allowing all light passing through the microlens 102 to enter the photosensitive sensor 106, only light with a particular direction can enter the photosensitive sensor 106 according to the design of the polarizing layer 104.

In some embodiments, a color filter can be further disposed between the microlens 102 and the polarizing layer 104 depending on the need. Also, in some embodiments, an anti-reflection layer and/or a buffer layer can be disposed between the polarizing layer 104 and the semiconductor substrate 108.

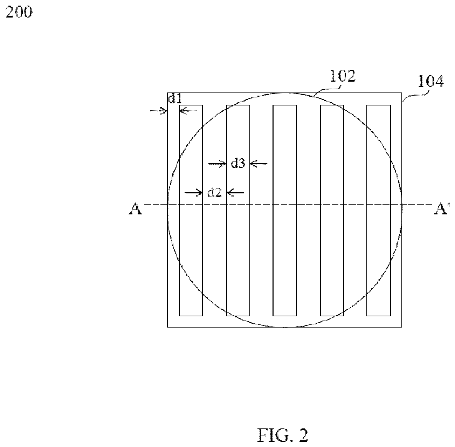

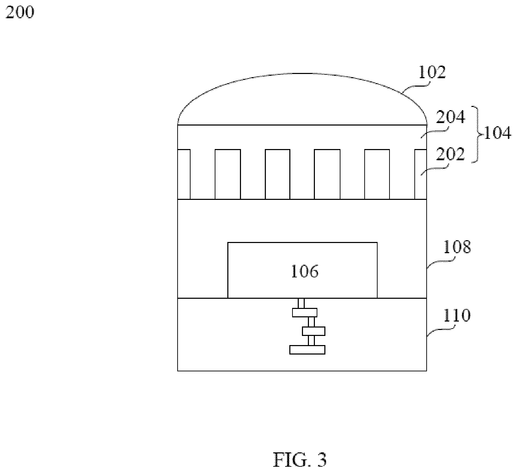

FIG. 2 illustrates a top view of the image sensor shown in FIG. 1 according to a further embodiment. As shown in FIG. 2, the polarizing layer 104 of the image sensor 200 has a vertical grid structure. Reference is made to both FIG. 2 and FIG. 3; FIG. 3 is a cross-sectional view of the image sensor taken along the cross-sectional line A-A' shown in FIG. 2. As could be seen in FIG. 2 and FIG. 3, the polarizing layer 104 includes a grid layer 202 and a capping layer 204, wherein the grid layer 202 includes grid lines with a specific height and surrounds the peripheral of the pixels in the image sensor 200 to prevent the optical crosstalk resulted from the light among pixels. Additionally, the grid layer 202 further includes grid lines that are disposed in parallel and cover the entire backside of the semiconductor substrate 108 of the pixel. The grid layer 202 may include metals; for example, the grid layer 202 may include titanium (Ti), tungsten (W), aluminum (Al), copper (Cu), and/or a combination thereof. However, the present application is not limited thereto, in some embodiments, the grid layer 202 may include materials other than metals. The capping layer 204 covers the grid layer 202 and fills the gaps between the grid lines of the grid layer 202. The capping layer 204 may include dielectric, such as silicon dioxide.

The grid layer 202 has a plurality of openings so that the underlying semiconductor substrate 108 is exposed, and the grid layer 202 is divided into a plurality of grid lines (e.g., a plurality of metal grid lines) by the plurality of openings; the number of the grid lines of the grid layer 202 as shown in FIG. 3 is for illustrative purpose, and the actual number of the grid lines of the grid layer 202 can be adjusted depending on the actual design. In the present embodiment, the grid lines of the grid layer 202 have substantially the same height and substantially the same spacing therebetween; specifically, the width of the grid lines of the grid layer 202 surrounding the peripheral of the pixels of the image sensor 200 is d1, the width of the grid lines of the grid layer 202 surrounding the peripheral of the pixels of the image sensor 200 is d1, the width of the grid lines of the grid layer 202 surrounding the peripheral of the pixels of the image sensor 200 is d1, the width of the grid lines that are disposed in parallel is d2, the spacing between the grid lines that are disposed in parallel is d3. In this embodiment, d2 and d3 are substantially the same, and are both about twice of the d1. However, the present application is not limited thereto; in some embodiments, the width or spacing of the grid lines of the grid layer 202 may have different heights or width.

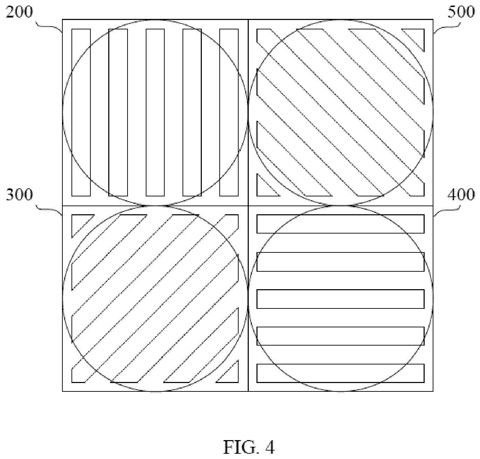

FIG. 4 is a top view showing four pixels of the image sensor according to one embodiment of the present application. The image sensor illustrated in FIG. 4 includes the pixel 200 illustrated in FIG. 2 and additional pixels 300, 400, and 500, respectively having a pattern different from pattern of the grid layer 202. In fact, the image sensor may comprise more than 4 pixels; for instance, the pixels 200, 300, 400, and 500 shown in FIG. 4 can be used as a least repeating pixel set, wherein the least repeating pixel set can be replicated in the horizontal and/or vertical direction in FIG. 4 to obtain the required size of the image sensor.

Specifically, the grid layer 202 of all of the pixels 200, 300, 400, and 500 has grid lines that surround the peripheral of the pixels, the grid layer 202 of the pixels 200, 300, 400, and 500 differs in the directions of the respective parallel grid lines thereof. As shown in FIG. 4, the direction of grid lines in the pixel 300 is the direction of grid lines in the pixel 200 rotated 45 degrees to the right; the direction of grid lines in the pixel 400 is the direction of grid lines in the pixel 300 further rotated 45 degrees to the right; the direction of grid lines in the pixel 500 is the direction of grid lines in the pixel 400 further rotated 45 degrees to the right. Hence, the direction of grid lines in the pixel 200 and the direction of grid lines in the pixel 400 are perpendicular to each other, whereas the direction of grid lines in the pixel 300 and the direction of grid lines in the pixel 500re perpendicular to each other.

The pixel arrangement shown in FIG. 4 may allow pixels 200, 300, 400, and 500 to receive light from different directions respectively, and use the light from said four directions to help calculate the ToF for improved accuracy. It should be noted that, in some embodiments, the complexity of the pixel configuration in FIG. 4 may be increased to further enrich the information available for subsequent applications. For instance, the rotation angle of the grid lines may be decreased from 45 degrees to 22.5 degrees, and the number of the pixels in the least repeating pixel set is increased to 8. Further, the pixels 200, 300, 400, and 500 in FIG. 4 do not have to be arranged in the manner shown. For example, in some embodiments, the location of pixel 300 and pixel 400 can be swapped.

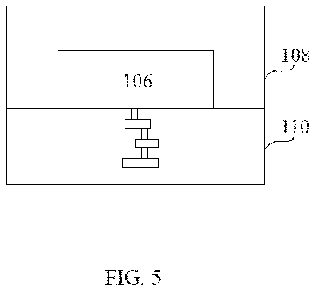

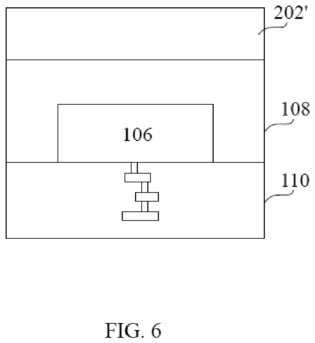

FIG. 5 to FIG. 9 are schematic flow diagrams illustrating the manufacturing flow of the image sensor 200 shown in FIG. 3. In FIG. 5, the semiconductor substrate 108 is first obtained, and the front side of the semiconductor substrate 108 has the back-end-of-line stack 110. Next, as shown in FIG. 6, a metal layer 202' is formed on the backside of the semiconductor substrate 108, for example, the metal layer 202' can be formed by a sputtering, electroplating, or evaporation. In some embodiments, an anti-reflection layer and/or buffer layer can be formed on the backside of the semiconductor substrate 108 before forming the metal layer 202'.

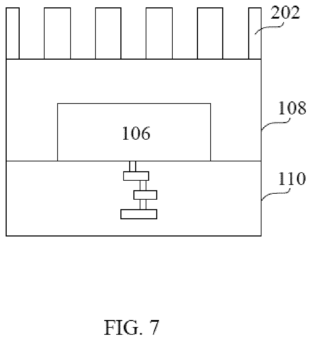

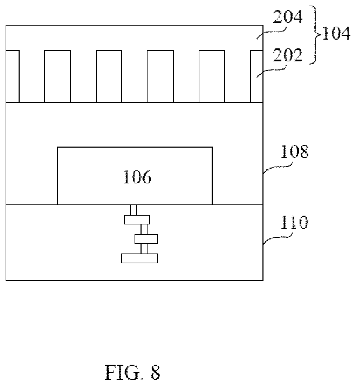

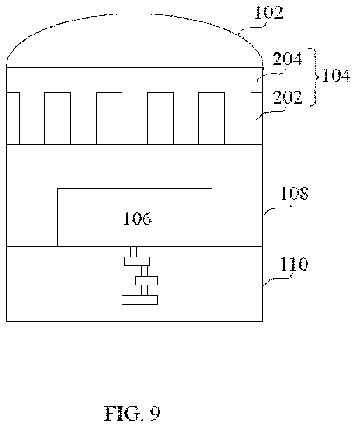

In FIG. 7, an etching process is used to form the pattern of the grid layer 202; for instance, the etching process is used to form the pattern of the metal grid layer of FIG. 4. Then in FIG. 8, the capping layer 204 is formed on the grid layer 202 to cover the grid layer 202 and fill the gaps between the grid lines of the grid layer 202, so that the capping layer 204 directly contacts the backside of the semiconductor substrate 108. The capping layer 204 may include dielectric, e.g., silicon dioxide. In some embodiments, a planarization process may be performed upon the upper surface of the capping layer 204, and after that, the grid layer 202 and the capping layer 204, together, form the polarizing layer 104. Last, in FIG. 9, the microlens 102 is formed, wherein the shape of the microlens 102 is determined depending on the need. Moreover, in some embodiments, a color filter may be further formed between the microlens 102 and the polarizing layer 104.

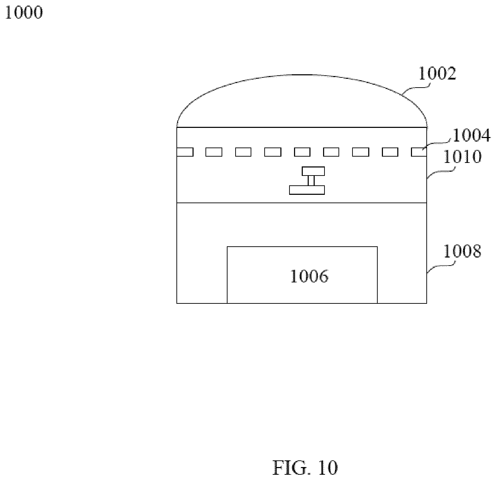

It should be noted that, the implementation of using the polarizing layer between the microlens and the photosensitive sensor to improve the accuracy of the ToF sensor is not limited to the backside illumination image sensor, and in some embodiments, it can be implemented using a front-side illuminated (FSI) image sensor. FIG. 10 is a cross-sectional view of one pixel of the image sensor according to another embodiment of the present application. It should be noted that, the image sensor 1000 may include a plurality of pixels, and only one pixel of the image sensor 1000 is shown in FIG. 10. In the present embodiment, the image sensor 1000 is a front-side illuminated image sensor 1000, which includes a semiconductor substrate 1008, a back-end-of-line stack 1010, and a microlens 1002. In this embodiment, the back-end-of-line stack 1010 is disposed over the front side of the semiconductor substrate 1008 as shown. The back-end-of-line stack 1010 includes an interlayer dielectric (ILD) layer and a metallization layer (e.g., metallization layer 1004) stacked in the interlayer dielectric layer. The interlayer dielectric layer may include low-k dielectric (i.e., dielectrics with a dielectric constant of less than about 3.9) or oxide. The metallization layers are electrically coupled with each other through vias and electrically coupled to the semiconductor substrate 1008 through contacts. The metallization layer, vias, and contacts may include metals, such as, aluminum-copper, geranium, copper, or some other metals.

The semiconductor substrate 1008 can be a bulk semiconductor substrate, such as, a bulk silicon substrate or silicon on insulator (SOI) substrate. The photosensitive sensor 1006 is disposed on the semiconductor substrate 1008. The microlens 1002 is arranged on the front side the semiconductor substrate 1008 so that back-end-of-line stack 1010 is disposed between the microlens 1002 and the semiconductor substrate 1008.

In the present embodiment, the metallization layer 1004 in the back-end-of-line stack 1010 is shaped so that it is used as the grid layer to achieve the effect of a polarizing layer, so that it is difficult for light that is not in a specific direction to pass through. That is, light first passes through the microlens 1002 and then enters the metallization layer (polarizing layer) 1004, and in this way, instead of allowing all light passing through the microlens 1002 to enter the photosensitive sensor 1006, only light with a particular direction can enter the photosensitive sensor 1006 according to the design of the metallization layer (polarizing layer) 1004. The metallization layer (polarizing layer) 1004 serving as the polarizing layer may have a shape that is the same as or similar to the shape of the grid layers in the image sensors 200, 300, 400, and/or 500; for example, it includes a plurality of grid lines that are disposed in parallel and covers the entire semiconductor substrate 1008; in some embodiments, the plurality of parallel grid lines are equally spaced.

In the present embodiment, the metallization layer 1004 of any layer of the back-end-of-line stack 1010 may be used as the polarizing layer, and the present application is not particularly limited. A color filter may be further disposed between the microlens 1002 and the back-end-of-line stack 1010 depending on the need.

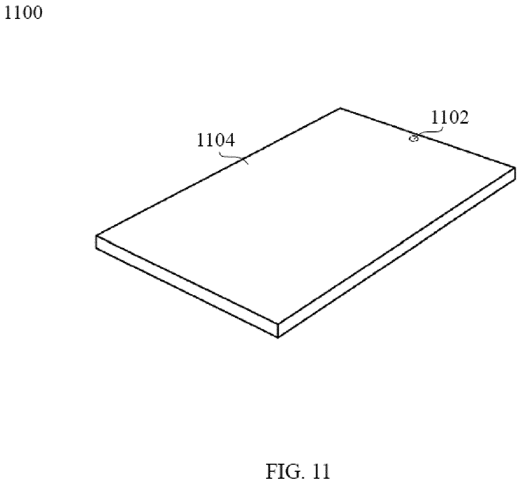

The present application further provides a chip, which includes the image sensor 100/1000, wherein the polarizing layer 104/1004 of the image sensor 100/1000 may have the shape of the image sensors 200, 300, 400, and/or 500. The present application further provides a hand-held device, wherein FIG. 11 is a schematic diagram illustrating the hand-held device according to one embodiment of the present application. The hand-held device 1100 includes a display screen assembly 1104 and an image sensor 1102. The hand-held device 1100 can be used to perform the ToF sensing and/or 3D image sensing for facial recognition. In the present embodiment, the hand-held device 1000 can be any hand-held electronic device such as a smartphone, personal digital assistant, hand-held computer system or tablet computer. The display screen assembly 1104 may include a display panel and protective cover plate, wherein the protective cover plate is disposed on the top of the display panel, and the image sensor 1102 is disposed under the display panel; for example, the image sensor 1102 may include the image sensor 100/1000, wherein the polarizing layer 104/1004 of the image sensor 100/1000 may have the shape of the image sensors 200, 300, 400, and/or 500. In the present embodiment, the display panel can be an organic light-emitting diode (OLED); however, the present application is not limited thereto.

The foregoing outlines features of several embodiments so that those skilled in the art may better understand various aspects of the present disclosure. Those skilled in the art should appreciate that they may readily use the present disclosure as a basis for designing or modifying other processes and structures for carrying out the same purposes and/or achieving the same advantages of embodiments introduced herein. Those skilled in the art should also realize that such equivalent embodiments still fall within the spirit and scope of the present disclosure, and they may make various changes, substitutions, and alterations thereto without departing from the spirit and scope of the present disclosure.

## Claims

1. An image sensor, **characterized in that** the image sensor comprises a semiconductor substrate and a plurality of pixels, wherein each pixel of the plurality of pixels comprises:
a photosensitive sensor, disposed on the semiconductor substrate;
a polarizing layer, disposed over the semiconductor substrate; and
a microlens, disposed over the polarizing layer so that the polarizing layer is between the microlens and the semiconductor substrate.

2. The image sensor of claim 1, wherein the polarizing layer comprises a grid layer.

3. The image sensor of claim 2, wherein the grid layer comprises titanium (Ti), tungsten (W), aluminum (Al), copper (Cu) and/or a combination thereof.

4. The image sensor of claim 2, wherein the grid layer comprises a plurality of grid lines disposed in parallel to cover the semiconductor substrate.

5. The image sensor of claim 4, wherein the polarizing layer further comprises a capping layer covering the grid layer.

6. The image sensor of claim 4, wherein the plurality of grid lines parallelly disposed in the grid layer are equally spaced.

7. The image sensor of claim 1, wherein each pixel of the plurality of pixels further comprises a back-end-of-line stack disposed between the microlens and the semiconductor substrate, and the polarizing layer comprises a metallization layer of the back-end-of-line stack.

8. The image sensor of claim 7, wherein the metallization layer comprises a plurality of grid lines disposed in parallel to cover the semiconductor substrate.

9. The image sensor of claims 1 to 8, wherein the plurality of pixels comprise a plurality of pixel sets, wherein each of the plurality of pixel sets comprises a first pixel and a second pixel, and the polarizing layer of the first pixel and the polarizing layer of the second pixel have different patterns.

10. The image sensor of claim 9, wherein the first pixel and the second pixel are adjacent to each other.

11. The image sensor of claim 9, wherein the grid layer of the polarizing layer of the first pixel and the grid layer of the polarizing layer of the second pixel have different patterns.

12. The image sensor of claim 10, wherein the grid layer of the first pixel comprises a plurality of first grid lines disposed in parallel, the grid layer of the second pixel comprises a plurality of second grid lines disposed in parallel, wherein the plurality of first grid lines and the plurality of second grid lines have different directions.

13. The image sensor of claim 12, wherein the difference in direction between the plurality of first grid lines and the plurality of second grid lines is 45 degrees.

14. The image sensor of claim 13, wherein each of the plurality of pixel sets further comprises a third pixel and a fourth pixel,
wherein the third pixel is adjacent to the second pixel, and the fourth pixel is adjacent to the first pixel, and the polarizing layers of the first pixel, the second pixel, the third pixel and the fourth pixel have different patterns.

15. The image sensor of claim 14, wherein the grid layers of the first pixel, the second pixel, the third pixel and the fourth pixel have different patterns.

16. The image sensor of claim 15, wherein the grid layer of the third pixel comprises a plurality of third grid lines disposed in parallel, the grid layer of the fourth pixel comprises a plurality of fourth grid lines disposed in parallel, wherein the plurality of first grid lines, the plurality of second grid lines, the plurality of third grid lines, and the plurality of fourth grid lines have different directions.

17. The image sensor of claim 16, wherein the difference in direction between the plurality of third grid lines and the plurality of fourth grid lines is 45 degrees, and the plurality of first grid lines and the plurality of third grid lines are perpendicular to each other.

18. A manufacturing method of an image sensor, **characterized by** comprising:
providing a semiconductor substrate;
forming a polarizing layer over the semiconductor substrate; and
forming a microlens over the polarizing layer.

19. The manufacturing method of the image sensor of claim 18, wherein the formation of the polarizing layer over the semiconductor substrate comprises:
forming a metal layer over the semiconductor substrate; and
etching the metal layer to obtain a grid layer.

20. The manufacturing method of the image sensor of claim 19, wherein the formation of the polarizing layer over the semiconductor substrate further comprises:
forming a capping layer to cover the grid layer.

21. A chip, **characterized by** comprises:
the image sensor of any of claims 1-17.

22. A hand-held device, configured to perform a time-of-flight detection, **characterized by** comprising:
a display panel; and
the image sensor of any of claims 1-17.
